(19) Europäisches Patentamt
European Patent Office
Office européen des brevets

(11) Publication number: **0 419 845 A2**

(12) # EUROPEAN PATENT APPLICATION

(21) Application number: **90116061.4**

(22) Date of filing: **22.08.90**

(51) Int. Cl.[5]: **C25D 5/56**, C25D 3/38, C23C 18/22

A request for addition of a missing page (page 13 from the originally filed description) has been filed pursuant to Rule 88 EPC. A decision on the request will be taken during the proceedings before the Examining Division (Guidelines for Examination in the EPO, A-V, 2.2).

The application is published incomplete as filed (Article 93 (2) EPC). The point in the description at which the omission obviously occurs has been left blank.

(30) Priority: **05.09.89 US 402372**

(43) Date of publication of application: **03.04.91 Bulletin 91/14**

(84) Designated Contracting States: **DE ES FR GB IT SE**

(71) Applicant: **GENERAL ELECTRIC COMPANY**
**1 River Road**
**Schenectady New York 12305(US)**

(72) Inventor: **Foust, Donald Franklin**
**1 Spring Valley Circle**
**Scotia, New York 12302(US)**
Inventor: **Bernstein, Lewis Andrew**
**77 Coventry Court**
**Voorheesville, New York 12186(US)**

(74) Representative: **Catherine, Alain**
**General Electric France Service de Propriété Industrielle 18 Rue Horace Vernet**
**F-92136 Issy-Les-Moulineaux Cedex(FR)**

(54) **Method for preparing metallized polyimide composites.**

(57) Metallized polyimide composites are prepared by depositing an electrolytic layer of metal onto an electrolessly-applied metal layer which is disposed on and chemically bonded to a polyimide substrate, the electrolytic metal layer being deposited from an electrolytic bath containing

A. about 50 to about 275 grams per liter of an aqueous acidic metal electrolyte,
B. about 30 to about 120 grams per liter of a strong acid,
C. about 20 to about 500 parts per million of halide ions,
D. about 0.5 to about 6% by volume of at least one organic chemical additive comprising an organic levelling agent, an organic brightener or a mixture of the foregoing.

These composites are characterized by improved surface characteristics and improved adhesion between the electroless metal layer and the polyimide surface.



Xerox Copy Centre

# METHOD FOR PREPARING METALLIZED POLYIMIDE COMPOSITES

## Background of the Invention

This invention relates to a method for preparing metallized polyimide composites. More particularly, this invention relates to a method for preparing metallized polyimide composites having improved surface qualities as well as improved adhesion between the polyimide substrate and the metal deposited thereon.

Printed circuit boards have become the dominant vehicle for mounting and interconnecting electronic components in order to manufacture a desired electronic circuit. The printed circuit board usually consists of a sheet of a dielectric substrate constructed from various filled or unfilled synthetic materials. The substrate is provided with a pattern of thin metal foil which functions as a conductive path on one or both sides. The paths or "traces" are usually formed of a conductive material such as copper, palladium, nickel or gold. The traces collectively define all of the electrical connections between components on the board, and are routed between appropriate locations.

Thermoplastic materials such as polyimides are particularly suitable for printed circuit board substrates because of their strength, heat resistance, dimensional stability, and easy moldability. However, polyimide substrates are not easily provided with a strongly adherent metal trace. The printed circuit, i.e., the plated metal conductive path, can be damaged or separated from the substrate during subsequent manufacturing steps or during use of the circuit board.

Several methods exist for increasing the adhesion of the conductive metal traces to polyimide substrates. Adhesion is generally measured as "peel strength", i.e., the force under controlled conditions required to peel the trace from the substrate. Some of these methods focus on modifying the polyimide surface prior to the application thereon of the metal layer, for example, by roughening the polyimide surface through chemical or mechanical means, while some methods focus on treating the polyimide surface with adhesion-promoting compounds.

It has been found, however, that for further processing, the metal layer must have not only excellent adhesion to the polyimide substrate, but also a smooth and shiny appearance.

Thus, a method for improving the surface appearance of the metal as well as the adhesion between the metal layer and the polyimide surface is desired.

Such a method is disclosed in copending, commonly owned Application Serial No. 207,462, to Foust et al. In that method, a polyimide-metal composite is provided with improved surface characteristics as well as improved adhesion between an electrolessly-applied metal surface and polyimide surface on which the electroless metal layer is disposed by means of two different electrolytically-applied metal layers. The electrolytic baths from which the electrolytic layers were deposited were both conventional baths known in the art. The first electrolytic layer, disposed on the surface of the electroless metal layer and containing no chemical additives such as brighteners and levelling agents, promoted metal-plastic adhesion but left a rough, matte finish. The second electrolytic layer, disposed on the surface of the first electrolytic layer and containing additives, provided a smooth and bright appearance without affecting the electroless metal-plastic adhesion. It was discovered by the applicants therein that the presence of additives in the first electrolytic layer resulted in a lower level of adhesion between the polyimide surface and the electroless metal layer while the omission of the additives in the first layer resulted in an exceptionally high level of adhesion between the polyimide surface and the electroless metal layer.

Although good metal-plastic adhesion and desirable surface characteristics were obtained in the application to Foust et al. discussed above, it would be desirable to achieve such characteristics by means of one electrolytic bath.

## Summary of the invention

The present invention provides a method for preparing a metallized polyimide composite comprising electrolytically applying a metal layer onto an electrolessly-applied metal layer which is disposed on and chemically bonded to a polyimide substrate, the electrolytically-applied metal layer being deposited from an electrolytic bath comprising

A. about 50 to about 275 grams per liter of an aqueous acidic metal electrolyte,

B. about 30 to about 120 grams per liter of a strong acid,

C. about 20 to 500 parts per million of halide ions,

D. about 0.5 to about 6% by volume of at least one organic chemical additive comprising an organic levelling agent, an organic brightener, or a mixture of the foregoing.

The surface of the metallized polyimide composite prepared in this invention is characterized by a smooth finish and bright appearance, and a high level of adhesion to the polyimide surface.

This invention further includes metallized polyimide composites prepared according to the method described above, as well as articles, e.g. printed circuit boards, which comprise the metallized polyimide composites.

The present invention is based on the discovery that the adhesion of the electroless metal to the polyimide surface is dependent upon the inorganic composition of the electrolytic metal bath. The invention is further based on the discovery that the presence of organic chemical additives in an electrolytic metal bath will not affect the electroless metal-polyimide adhesion if the bath has a particular inorganic formulation. Thus, improved metal-polyimide adhesion and excellent metal surface characteristics can be obtained using one electrolytic metal bath when the bath has a particular inorganic formulations

## Brief Description of the Drawings

Figure 1 is a graph showing the relationship between the stress of the electrolytic metal deposit and the presence of additives in the electrolytic plating bath.

## Detailed Description of the Invention

The present invention is directed to preparing metallized polyimide composites wherein the metal is characterized by a smooth and shiny surface appearance, and excellent adhesion to the polyimide surface.

The attainment of these desirable properties in this invention is dependent upon the inorganic formulation, i.e., the "inorganic matrix", of the electrolytic plating bath. The term "inorganic matrix" refers herein to an electrolytic acid metal bath without organic brighteners or levellers.

Illustrative metals used to form the electrolytic and electroless layers in the present invention include copper, palladium, nickel and gold. Copper is usually the metal of choice when forming a printed circuit.

Electroplating baths are known in the art and are described, for example, in U.S. Patent 4,555,315. A description of baths for plating copper or various other metals is given in the Kirk-Othmer Encyclopedia of Chemical Technology , Third Edition, in Vol. 8, beginning on page 826. Baths used to apply a layer of copper onto an electrolessly-applied layer typically include an aqueous acidic copper electrolyte such as those of the acidic copper sulfate or acidic copper fluoroborate type; halide ions, such as chloride and/or bromide ions; and various other components well-known in the art. The thickness of the electrolytic metal layers will depend upon the desired end use of the metal-coated substrate.

The electrolytic metal layer may be in the form of a pattern. Exemplary patterning methods are described in U.S. Patent 3,562,005, incorporated herein by reference.

The particular bath contents will depend on the particular plastic serving as the substrate and also on the particular metal being deposited thereon. Although the compounds present in the electrolytic plating bath used in this invention are those which are used in conventional plating baths as described above, the amounts of these compounds present in the electroplating bath are critical to the present invention.

Accordingly, the electrolytic plating bath used in the present invention contains about 50 to about 275, preferably about 100 to about 175, grams per liter of an aqueous acidic metal electrolyte; about 30 to about 120, preferably about 40 to about 100, grams per liter of a strong acid; about 20 to about 500, preferably about 50 to about 500, parts per million, of halide ions; and about 0.5 to about 6%, preferably about 2 to about 4%, by volume of chemical additives.

Suitable aqueous acidic copper electrolytes include ccpper sulfate, copper fluoroborate, copper chloride, copper nitrate, and the like, with copper sulfate being preferred.

The acids used in the above-described bath typically have a high ionic dissociation constant for maximum conductivity.

Examples of suitable strong acids include sulfuric acid, hydrochloric acid, nitric acid, fluoroboric acid, sulfamic acid and the like. Sulfuric acid is preferred.

Examples of suitable halide ions include bromide and chloride ions and the like, with chloride ions being preferred. Generally, the chloride ions are supplied in the form of hydrochloric acid.

Suitable organic chemical additives containing brighteners and levelling agents are known in the art and are described, for example, in Decorating Plastics , edited by James M. Margolis, Hanser Publishers, 1986;

by J.D. Reid and A.P. David in Plating and Surface Finishing , January 1987, pp.66-70; in Modern Electroplating , edited by Frederick A. Lowenheim, Third Edition, John Wiley and Sons, Inc.; in German Application No. 3,721,985 and in the United Kingdom Patent application of D. Morrissey et al., GB2123036A, all of which are incorporated by reference herein.

Non-limiting examples of brighteners, some of which can also function as levelling agents, include organic disulfide compounds, e.g., aromatic, heterocyclic and aliphatic disulfide compounds; aromatic sulfonic acids, e.g., benzene sulfonic acid, 1,3,6-naphthalene sulfonic acid and the like; aromatic sulfonamides, e.g., p-toluene sulfonamide and the like; aromatic sulfonimides, e.g., o-benzoic sulfonimide (saccharin) and the like; heterocyclic sulfonic acids, e.g., thiophen-2-sulfonic acid and the like; aromatic sulfinic acids, e.g., benzene sulfinic acid and the like; and ethylenic aliphatic sulfonic acids, e.g., allyl sulfonic acids and the like.

Non-limiting examples of suitable levellers include polyorganic oxides and those described, for example, in U.S. Patent 4,810,333, and incorporated by reference herein, which include surfactant water soluble organic compounds such as compounds containing multiple oxyethylene groups, for example, polyoxyethylene polymers having about 20 to about 150 repeating units, and block copolymers of polyoxyethylene and polyoxypropylene. Polyethylene glycol is also a suitable levelling agent.

For purposes of the present invention, component D is preferably one of the following:

(1) Copper Gleam PCM Plus, available from Lea Ronal Company and containing mixtures of disulfide brighteners and polyorganic oxide levelling agents;

(2) PC Gleam, a product of the Lea Ronal Company and containing mixtures of disulfide brighteners and polyorganic oxide levelling agents;

(3) PC667, available from the Electrochemicals Company and containing an organic dye system;

(4) Pluronic® L31, a product of the BASF Company and containing polyorganic oxides as levelling agents. Examples of other chemical additives are stress relievers, depolarizers, plating suppressors, and wetting agents, as well as agents used for hardening, grain refining, reducing trees, and limiting current density. Thus, the term "organic chemical additives" as used herein is meant to include any of the above-mentioned agents.

The choice of a particular polyimide material for plating according to the present invention is not critical. Polyimides are well-known in the art, and are described, for example, in the Kirk-Othmer Encyclopedia of Chemical Technology , Third Edition, Volume 18. Especially preferred polyimides for the present invention are those commonly referred to as "polyetherimides" - for example, those formed by the reaction of (2,2-bis[4-(3,4-dicarboxyphenoxy)phenyl]propane dianhydride with phenylene diamine. Examples of polyetherimides and methods for their preparation are described, for example, in U.S. Patents 3,983,093 and 4,360,633, issued to Williams, III et al.. and Bolon et al.., respectively. Both of these patents are incorporated herein by reference.

The polyimides may contain various amounts of fillers or reinforcing agents, all of which are well-known in the art. Illustrative fillers and reinforcing agents are disclosed in U.S. Patent 4,525,508, incorporated herein by reference. These materials include talcs, mica, aluminum silicates (clay), zinc oxide, calcium metaphosphate, titanium dioxide, carbon black, franklinite, precipitated or natural calcium carbonate, glass fibers, glass spheres, silicone-polyimide copolymeric materials, carbon fibers, and the like, as well as mixtures thereof.

These polyimides may of course contain various other additives, such as pigments, ultraviolet radiation absorbing agents, impact modifiers, plasticizers, antioxidants, stabilizers, processing aids, antistatic agents, and the like.

The substrates of the present invention may be in a variety of shapes and sizes. For example, the substrate may be a printed circuit board having flat or curved surfaces, which can also include various cavities, raised regions, and through-holes; and can comprise two or more discrete polyimide layers, e.g., a multi-level circuit board.

The polyimide surface should be degreased before any further steps are taken. The term "degreased" means a polyimide substrate having its surface free of oil, molding compounds, finger prints or extraneous material. Various degreasing agents may be used, with the proviso that they not in any way degrade the polyimide surface. Suitable degreasing agents include detergents such as Shipley Acid Cleaner 1118 and Shipley Cleaner-Conditioner 1175A, both available from the Shipley Company, Metex 9627, a product of the MacDermid Corporation, and Microdetergent, available from the International Products Corporation. Other suitable degreasing agents include halo hydrocarbon Freon® solvents, such as 1,1,2-trichloro-1,2,2-trifluoroethane and mixtures of 1,1,2-trichloro-1,2,2-trifluoroethane with acetone or methanol and nitromethane. In the event that one of the detergents mentioned above is used, it is essential that the substrate be perfectly dry prior to contact with one of the etching compounds, particularly sulfuric acid,

described below. Residual water will cause the concentration of the sulfuric acid to decrease. In addition, water droplets on the polyimide surface will act like grease residues, preventing the reaction of the sulfuric acid with the plastic. In both cases, decreased adhesion will result.

After the polyimide surface has been degreased, it must undergo a pretreatment regimen that will allow the polyimide surface to become chemically bonded to the electroless metal subsequently applied to it. The method of pretreatment is not critical as long as a chemical bond will be formed between the polyimide surface and the electroless metal.

Suitable methods for pretreating the polyimide surface are described, for example, in copending, commonly owned applications serial nos. 207,462 and 331,715, both to Foust et al, and U.S. Patent No. 4,775,449 to Dumas et al., all of which are incorporated by reference herein in their entirety.

Generally, the pretreatment comprises the steps of:

(A) mildly etching the surface of the polyimide, resulting in the formation of a residual film on the surface of the polyimide,

(B) contacting the etched polyimide surface with a basic solution,

(C) removing the residual film formed on the surface of the polyimide after the mild etching step.

Examples of mild etching compounds suitable for use on the polyimide surface include sulfuric acid, N,N-dimethylformamide, N-methyl-2-pyrrolidone, pyridine, tetrahydrofuran, and methylene chloride.

Sulfuric acid is the preferred mild etching compound because of its low cost and miscibility with water, and is preferably used in highly concentrated form, i.e., at least about 85% for this invention.

Treatment with the mild etching compound may be carried out for about 15 seconds to about 5 minutes, and is usually followed by a water rinse.

A residual film of varying thickness is formed on the polyimide surface during treatment with the mild etching compound. The film remains on the surface even after rinsing. The film can be treated with a basic (i.e., alkaline) solution for about 30 seconds to about 10 minutes which appears to modify the residual film, making it less adherent to the polyimide surface. Suitable basic solutions include those formed by dissolving 0.1 molar(M) to about 10M of a basic compound such as sodium hydroxide, potassium hydroxide, tetramethylammonium hydroxide, and mixtures thereof in a solvent such as water.

After the surface has been treated with the basic solution and rinsed, the loosened residue may be removed according to various known procedures. Removal of the residual film or white residue is essential to optimize rhe adhesion of any subsequently deposited electroless metal on the polyimide substrate.

According to U.S. Patent No. 4,775,449 to Dumas et al., previously cited and incorporated by reference herein , the loosened residue can be removed by treatment with a solution comprising an alcohol and one of the etching solvents described above, with the proviso that the etching solvent be one which would not react with the alcohol. For example, sulfuric acid reacts with methanol and thus would not be suitable for use in this step. Methanol is the preferred alcohol because of its ability to quickly remove the loosened residue. In the method disclosed in the application to Foust et al., Serial No. 207,462, the film residue is removed by contacting of the surface with a cationic surfactant. The central atom of this type of compound is usually a nitrogen or phosphorus cation, and often bonds to one or more organic side chains, e.g., quaternary ammonium salts, or is part of an organic heterocyclic system such as pyridine.

The preferred cationic surfactants are cetylpyridinium chloride monohydrate, cetylpyridinium bromide monohydrate, dodecyltrimethylammonium bromide, and hexadecyltrimethylammonium bromide. In terms of cost, availability and effectiveness, cetylpyridinium chloride monohydrate is most preferred.

In a preferred method for removing the loosened residue from the polyimide substrate, as disclosed in the application to Foust et al., Serial No. 331,715, after the polyimide has been treated with the basic solution and rinsed, the substrate is immersed into an aqueous solution of an alkali metal permanganate, and optionally an alkali metal hydroxide. Treatment with the permanganate solution should be carried out at a temperature of 25°C to 85°C for a period of 2 to 20 minutes. The alkali metal permanganate preferably includes potassium or sodium permanganate.

After rinsing, the treated polyimide substrate is found to be completely free of the white residue but a manganese oxide residue remains on the polyimide surface. The manganese residue is readily removed by treating the polyimide substrate with a reducing agent, such as an aqueous solution of hydroxylamine hydrochloride by immersing the polyimide substrate into the reducing bath. The resulting polyetherimide substrate can then be rinsed and allowed to dry to form a polyetherimide substrate having a chemically altered surface rendering it hydrophilic. Its modified surface is capable of being activated even after an extended period of time with a tin-palladium colloid in a standard manner and metallized with a electrolessly deposited metal such as copper. Superior adhesion between the deposited metal and the polyimide surface can be achieved, without the use of an adhesion promoter, such as thiourea.

If the polyimide surface is pretreated according to the methods disclosed in the Dumas et al. patent or

the application to Foust et al., Serial No. 207,402, treatment with an adhesion-promoting compound, as detailed therein, is needed.

In one adhesion-promoting procedure, the polyimide surface is treated with an adhesion promoter characterized by the presence of an

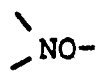

moiety.

Adhesion-promoting compounds characterized by the presence of an

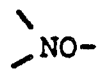

moiety are described in the Dumas et al. patent and include 0, N-dimethylhydroxylamine hydrochloride, acetone oxime, 2-pyridine aldoxime, N-hydroxyphthalimide, and 1-hydroxybenzotriazole·$H_2O$. An especially preferred adhesion-promoting compound of this type is hydroxylamine, or a salt of hydroxylamine.

In an alternative adhesion-promoting treatment, adhesion-promoting compounds are used which contain an organic double bond, as described in the application to Foust et al., Serial No. 103,618, filed September 28, 1987, and incorporated herein by reference.

Examples of these compounds which are suitable for use herein include thiosemicarbazide hydrochloride, 2,4-

3,011,920 and 3,841,881, issued to Shipley and Feldstein et al., respectively, both of which are also incorporated herein by reference.

After surface activation and rinsing, electroless plating can be undertaken. Electroless baths are well-known in the art and are generally described in the Kirk-Othmer Encyclopedia of Chemical Technology , 3rd Edition, Volume 8, the contents of which are incorporated herein by reference. The selection of a particular bath or electroless plating process is not critical to the present invention. The contents of the bath and the particular plating parameters, e.g., temperature, pH, and immersion time, will of course depend on the particular plastic serving as the substrate, and also upon the particular metal being deposited thereon. Suitable plating baths include the Shipley Cuposit® 250 system and the Enthone® 406 system. Furthermore, the Dumas et al. patent mentioned above lists suitable electroless plating formulations. Immersion times, bath temperatures, and other operating parameters can be determined and controlled according to manufacturers' suggestions. Those having ordinary skill in the plating arts will be able to determine the most appropriate plating regimen for a particular situation.

The polyimide surface can then be subjected to a heat treatment after electroless deposition of the metal. Oven heating of the entire article, i.e., substrate with metal thereon, is sufficient, although any heating method is suitable.

The electrolytic metal layers may be deposited according to electroplating plating processes known in the art. Typically, the electroplating bath for copper is operated at a temperature ranging from about 16° C to about 38° C, with a cathode current density in the range of about 1 ASF to about 80 ASF. The thickness of the electrolytically- applied metal layer will depend upon the desired end use of the metal-coated substrate.

After deposition of the electrolytic layer, the substrate may be rinsed again with water and then heat-treated to further enhance adhesion of the electroless metal layer to the substrate. A typical heat treatment for this step involves temperatures ranging from about 75° C to about 150° C for a time period ranging from

about 1 hour to about 24 hours.

The result of the electrolytic deposition is a metallized polyimide composite having a smooth, bright metal layer and a high level of adhesion between the electroless metal layer and the polyimide substrate.

In preferred embodiments, an article prepared by the method of this invention usually has an electroless metallization layer which is about .025 to about 6.25, preferably about 1 to about 2, microns thick, and an electrolytically-applied layer of about 25 microns.

Articles of various embodiments of this invention are suitable as printed circuit boards which would contain metallic layers as described herein in a printed circuit pattern or "trace".

The present invention will be further understood from the description of specific examples which follow. These examples are intended for illustrative purposes only and should not be construed as a limitation upon the broadest aspects of the invention. All liquid ratios are by volume, unless otherwise indicated.

In the following examples, adhesion of the metal to the substrate was evaluated by measuring the force necessary to peel strips of the metal from the substrate surface. In the test, the metal surface of each plated sample is etched into 1/8 inch strips. An end of each strip is clipped to an Ametek digital force measuring gauge which is connected to a computer processor. Force values required to lift the metal strips from the substrate are converted by the computer into pounds per inch peel values. Multiple peel values for each strip are obtained and then averaged.

Surface roughness was determined by means of a profilometer, wherein a stylus was moved across the surface of a plated sample and, as the stylus traveled across the surfaces, its motion perpendicular to the surface was measured and averaged.

The stress of the deposit was measured by means of a contractometer, wherein metal was deposited onto a metal helix having one stationary end and one end attached to a needle which records the expansion or contraction of the helix as it is being plated, such movement being indicative of the tensile and compressive stresses being exerted on the helix.

Examples 1-10

Examples 1-10 illustrate the dependence of the electroless copper-polyetherimide surface adhesion on the formulation of the inorganic matrix of the electrolytic plating bath. In these examples, the composition of the inorganic matrix varied as indicated in Table I below.

Polyetherimide samples having 30% by weight milled glass fibers dispersed therein were treated according to the following regimen:

| Step | Procedure [a] | Time (minutes) |
|---|---|---|
| A | 1,1,2-trichloro-1,2,2-trifluoroethane | 2 |
| B | Dry the substrate | - |
| C | Concentrated sulfuric acid | 0.5 |
| D | Rinse in water | 2 |
| E | Potassium hydroxide in water (5M) | 5 |
| F | Rinse in water | 2 |
| G | Treatment with cationic surfactant[b], 50° C | 5 |
| H | Rinse in water | 2 |
| I | Treatment with adhesion-promoter [c], 75° C | 10 |
| J | Rinse in water | 2 |
| K | Shipley Cleaner/Conditioner 1175A (2.5% by volume in water), 65° C | 5 |
| L | Rinse in water | 2 |
| M | Shipley Cataprep® 404 | 1 |
| N | Shipley Cataposit® 44 (1.5% in water by volume, 44° C) | 3 |
| O | Rinse in water | 2 |
| P | Shipley Accelerator® 19 | 3 |
| Q | Rinse in water | 2 |
| R | Shipley Cuposit® 250, 48° C | 30 |
| S | Rinse in water | 2 |
| T | Heat treatment at 75° C | 120 |
| U | Rinse in 10% $H_2SO_4$ | 0.5 |
| V | Plating in electrolytic copper bath[d] | 60 |
| W | Rinse in water | 2 |
| X | Dry | |
| Y | Heat treatment at 95° C | 16 hrs |

(a) Substrates were immersed in the liquid components
(b) 1% by weight cetylpyridinium chloride, 0.05% by weight AF9000 antifoaming agent, in water.
(c) 12.5% by weight thiourea in water, along with 1% by weight citric acid.
(d) plating at 36 ASF to 2 mils total thickness.

After being cooled to room temperature, the samples were tested for adhesion by the method described above. The results are shown in Table I below.

Table I

| Effect of Inorganic Matrix Composition on Copper-Polyetherimide Adhesion | | | | |
|---|---|---|---|---|
| Example No. | $CuSO_4 \cdot 5H_2O$(g/L) | $H_2SO_4$(g/L) | $Cl^-$(ppm) | Average Adhesion (lb/in)[a] |
| 1 | 50 | 30 | 20 | 7.1 |
| 2 | 50 | 120 | 100 | 5.7 |
| 3 | 100 | 100 | 150 | 10.2 |
| 4 | 125 | 60 | 50 | 10.7 |
| 5 | 125 | 60 | 200 | 11.8 |
| 6 | 140 | 50 | 175 | 11.5 |
| 7 | 175 | 100 | 500 | 10.5 |
| 8 | 175 | 40 | 150 | 11.5 |
| 9 | 200 | 120 | 100 | 8.6 |
| 10 | 275 | 60 | 150 | 7.0 |

[a] Industry standard for adhesion is 5.0 lb.in.

The data shown in Table I indicates that the adhesion of the electroless copper to the polyetherimide surface is dependent upon the inorganic matrix.

However as shown in Table II below, the copper deposits from such a "nonadditive" electrolytic plating baths are unacceptably rough.

## Examples 11-17

Various samples were treated as in Examples 1-10 above, except that additives were added to the electrolytic baths in examples 12, 14-16. The compositions of the inorganic matrices of the electrolytic plating baths used in these examples were as follows:

Inorganic Matrix I - 125 g/L $CuSO_4 \cdot 5H_2O$,60 g/L $H_2SO_4$,50 ppm $Cl^-$

Inorganic Matrix II - 140 g/L $CuSO_4 \cdot 5H_2O$, 50g/L $H_2SO_4$,175 ppm $Cl^-$

Inorganic Matrix III - 200 g/L $CuSO_4 \cdot 5H_2O$, 120g/L $H_2SO_4$,100 ppm$Cl^-$ The results for these examples are provided in Table II below.

Table II

| Effect of Additives on Adhesion | | | | | |
|---|---|---|---|---|---|
| Example No. | Inorganic Matrix | Additive | Concentration of Additive | Average Adhesion(lb/in) | Average Surface Roughness (microns)[d] |
| 11 | I | -- | -- | 10.7 | 3 |
| 12 | I | PCM +[a] | 3% | 10.8 | 0.5 |
| 13 | II | - | - | 11.5 | 2.5 |
| 14 | II | PCM + | 3 1/2% | 10.7 | -- |
| 15 | II | PC667[b] | 3% | 10.8 | .25 |
| 16 | II | 892[c] | 2%M/2%R | 10.7 | -- |
| 17 | III | -- | -- | 8.6 | -- |

[a] Lea Ronal Copper Gleam PCM +, which contains a mixture of disulfide brighteners and polyorganic oxide levelers.
[b] Electrochemicals Electro-Brite PC667, which contains an organic dye system.
[c] Shipley Electroposit®892, containing a mixture of disulfide brighteners and polyorganic oxide levellers.
[d] As measured by a profilometer.

The results given in Table II indicate that when chemical additives are added to an optional inorganic matrix, a smooth, shiny deposit with no loss of metal-plastic is produced. These additives, while not affecting the adhesion of the electroless copper to polyetherimide surfaces, do change the surface appearance, grain structure, and stress of the subsequent deposit as shown in Figure 1. The graph in Figure 1 shows that the stress of the subsequent deposit increased as metal was deposited from the non-additive containing electrolytic bath used in Example 12. The stress of the subsequent deposit was lower when metal was deposited from the additive-containing bath of Example 13, and decreased as metal was deposited from the additive-containing electrolytic bath used in Example 15.

Examples 18-27

In Examples 18-25, samples of polyetherimide having 30% by weight milled glass fibers dispersed therein were subjected to the steps listed in Examples 1-10 above.

In Examples 26 and 27, the glass-containing polyetherimide samples were treated according to the following regimen:

| Step | Procedure [a] | Time (Minutes) |
|---|---|---|
| A | 1,1,2-trichloro-1,2,2-trifluoroethane | 2 |
| B | Dry | - |
| C | Concentrated sulfuric acid, 96% room temperature | 0.5 |
| D | Rinse in water | |
| E | Potassium hydroxide (5N), room temperature | 5 |
| F | Potassium permanganate (15g/L), Potassium hydroxide (1.2N), 75°C | 5 |
| G | Rinse in water | 2 |
| H | Shipley Circuposit MLB Neutralizer 216, 53°C | 5 |
| I | Rinse in water | 2 |
| J | Shipley Cleaner-Conditioner 1175A, 65°C | 5 |
| K | Rinse in water | 2 |
| L | Shipley Cataprep 404, room temperature | 1 |
| M | Shipley Cataposit 44, (1 1/2%), 44°C | 3 |
| N | Rinse in water | 2 |
| O | Shipley Accelerator 19, room temperature | 3 |
| P | Rinse in water | 2 |
| Q | Shipley Cuposit 251, 48°C | 30 |
| R | Rinse in water | 2 |
| S | Dry | - |
| T | Heat treatment at 110°C | 60 |
| U | Plating in electrolytic copper bath [b] | 60 |
| V | Rinse in water | 2 |
| W | Dry | - |
| X | Heat treatment at 110°C | 17 hrs |

[a] Substrates were immersed in the liquid components
[b] Plating at 30 ASF at room temperature to 1.6 mils total thickness

In Examples 18-21, the formulations of the inorganic matrices were within the scope of those used in the application to Foust et al., application Serial No. 207,462. The inorganic matrices used in Examples 22-25 were within the scope of the present invention. The samples were then tested for adhesion according to the procedure previously described herein. The results are shown in Table III below.

Table III

| Effect of Inorganic Matrix and Additives on Adhesion | | | | | |
|---|---|---|---|---|---|
| Example No. | $CuSO_4 \cdot 5H_2O$(g/L) | $H_2SO_4$(g/L) | $Cl^-$(ppm) | Additive | Adhesion Avg. |
| 18 | 81 | 197 | 45 | PCM+ | 6.3 lb/in |
| 19 | 92 | 188 | 38 | L31[a] | 6.6 lb/in |
| 20 | 75 | 190 | 50 | PC667 | 5.2 lb/in |
| 21 | 125 | 60 | 50 | -- | 10.0 lb/in |
| 22 | 140 | 50 | 175 | PCM+ | 10.7 lb/in |
| 23 | 140 | 50 | 175 | PC667 | 10.8 lb/in |
| 24 | 140 | 50 | 175 | 892 | 10.7 lb/in |
| 25 | 140 | 50 | 175 | -- | 11.5 lb/in |
| 26 | 146 | 50 | 175 | PC667 | 13.5 lb/in |
| 27 | 100 | 200 | 75 | PCM+ | 9.2 lb/in |

[a]BASF Pluronic® L31, containing polyorganic oxides as levelling agents.

The results shown in Table III indicate that while organic brighteners and levellers do not affect

adhesion, the formulation of the inorganic matrix is vital to the electroless copper-polyetherimide surface adhesion.

Examples 28-33

Polyetherimide substrates containing 30% glass were pretreated, adhesion promoted-treated, and electroless plated as in Examples 1-10 above. Selected substrates were then electrolytically plated in one of the baths listed in Table IV below.

The inorganic matrices used in Examples 28 and 29 were within the scope of the Foust et al.. application Serial No. 207,462, while those used in Examples 30-33 were in accordance with the present invention. The samples were then tested for adhesion and surface roughness, and the results are shown in Table 4.

Table IV

Effect of Inorganic Matrix and Additives on Adhesion and Surface Roughness

| Example No. | $CuSO_4 \cdot 5H_2O$ (g/L) | $H_2SO_4$ (g/L) | HCl (ppm) | PC667 (%) | Average Peel Strength (lb/in) | Average Surface Roughness(Å) |
|---|---|---|---|---|---|---|
| 28 | 79 | 186 | 44 | 0 | 8.6 | 12,000 |
| 29 | 79 | 186 | 44 | 0.5 | 9.5 | 4,000 |
| 30 | 145 | 53 | 181 | 0 | 11.6 | 20,000 |
| 31 | 145 | 53 | 181 | 2 | 11.4 | 4,000 |
| 32 | 145 | 53 | 181 | 4 | 13.1 | 3,000 |
| 33 | 145 | 53 | 181 | 6 | 14.0 | 5,000 |

It can be seen from the results shown in Table 4 that the inorganic matrix affects adhesion while the chemical additive affects the surface properties of the metal deposit.

Although the invention has been described in its preferred forms with a certain degree of particularity, it is understood that the present disclosure is by way of example, and that numerous changes may be made without departing from the spirit and scope of this invention.

**Claims**

1. A method for preparing a metallized polyimide composite comprising electrolytically applying a metal layer onto an electrolessly-applied metal layer which is disposed on and chemically bonded to a polyimide substrate, the electrolytic metal layer being deposited from an electrolytic bath comprising

A. about 50 to about 275 grams per liter of an aqueous acidic metal electrolyte,

B. about 30 to about 120 grams per liter of a strong acid,

C. about 20 to about 500 parts per million of halide ions,

D. about 0.5 to about 6% by volume of at least one organic chemical additive comprising an organic levelling agent, an organic brightener or a mixture of the foregoing.

2. A method according to claim 1 wherein the amount of the aqueous acidic metal electrolyte in the electrolytic bath is about 100 to about 175 grams per liter.

3. A method according to claim 1 wherein the amount of the strong acid in the electrolytic bath is about to about 100 grams per liter.

4. A method according to claim 1 wherein the amount of halide ions in the electrolytic bath is about 50 to about 500 parts per million.

5. A method according to claim 1 wherein the amount of chemical additives in the electrolytic bath is about 3% by volume.

6. A method according to claim 1 wherein the acidic metal electrolyte is copper sulfate.

7. A method according to claim 1 wherein the strong acid is sulfuric acid.

8. A method according to claim 1 wherein the halide ions are chloride ions.

9. A method according to claim 1 wherein the brightener is an organic disulfide compound.

10. A method according to claim 1 wherein the levelling agent is a polyorganic oxide compound.

11. A method according to claim 1 wherein component D comprises at least one polyorganic oxide levelling agent.

12. A method according to claim 1 wherein component D comprises a mixture of organic disulfide brighteners and polyorganic oxide levelling agents.

13. A method according to claim 1 wherein component D further comprises an organic dye.

14. A method according to claim 1 wherein each metal layer is formed of copper.

15. A method according to claim 1 wherein the chemical bonding of the electrolessly-applied metal layer and the polyimide substrate is effected by means of a pretreatment of the polyimide substrate prior to deposition of the electrolytically applied metal layer, wherein the pretreatment comprises the steps of

(A) mildly etching the surface of the polyimide, resulting in the formation of a residual film on the surface of the polyimide,

(B) contacting the etched polyimide surface with a basic solution, and

(C) removing the residual film formed on the surface of the polyimide after the mild etching step.

16. A method for preparing a metallized polyimide composite comprising the steps of:

(A) mildly etching the surface of a polyimide substrate,

(B) contacting the surface with a basic solution,

(C) contacting the surface with a cationic surfactant which is capable of removing a residual film formed on the polyimide surface after the mild etching step,

(D) treating the polyimide surface with an adhesion promoter selected from the group consisting of compounds characterized by the presence of an

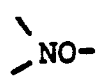

moiety and compounds containing an organic double bond,

(E) electrolessly applying a metal layer onto the surface,

(F) electrolytically applying a metal layer onto the surface of the electrolessly-applied metal layer, the electrolytically-applied metal layer being deposited from an electrolytic metal bath comprising:

A. about 100 to about 175 grams per liter of copper sulfate,

B. about 40 to about 10u grams per liter of sulfuric acid,

C. about 50 to about 500 parts per million of chloride ions,

D. about 2 to about 4% by volume of an organic chemical additive comprising a mixture of organic disulfide brighteners and polyorganic oxide levelling agents.

*Fig. 1*

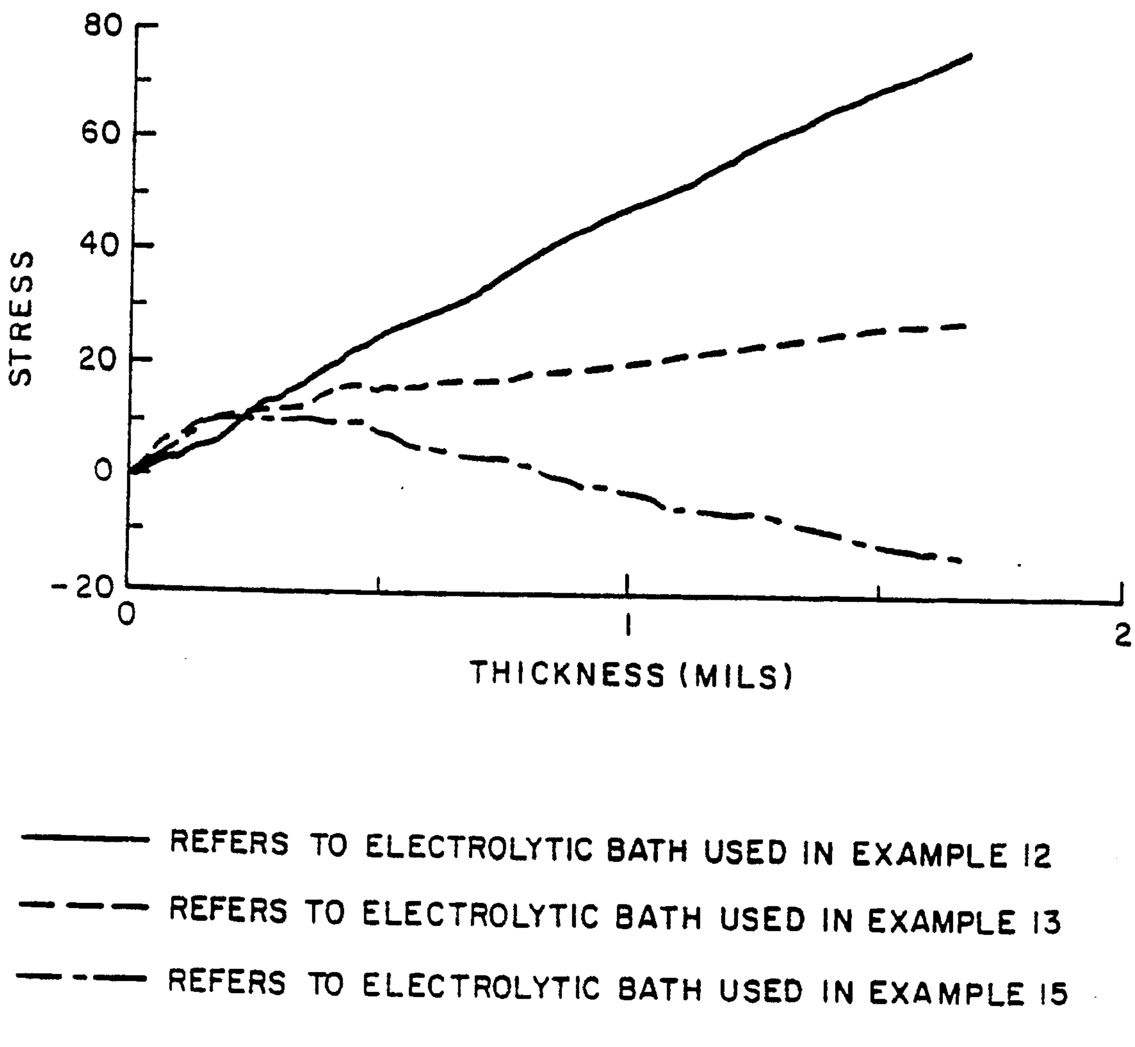
80
60
40
20
0
-20
STRESS
0
1
2
THICKNESS (MILS)
REFERS TO ELECTROLYTIC BATH USED IN EXAMPLE 12
REFERS TO ELECTROLYTIC BATH USED IN EXAMPLE 13
REFERS TO ELECTROLYTIC BATH USED IN EXAMPLE 15